# EUROPEAN PATENT APPLICATION

(11) **EP 4 056 402 A1**
(43) Date of publication of application: **14.09.2022**
(21) Application number: 21161849.1
(22) Date of filing: 10.03.2021
(51) Int. Cl.: B60L 3/00, B60L 50/64, B60L 58/12

(54) **A SAFETY SYSTEM FOR DETECTING A CRITICAL CONDITION IN A BATTERY PACK**

(71) Applicant: VOLVO TRUCK CORPORATION, 405 08 Göteborg (SE)
(72) Inventor: AHMED, Istaq, 422 44 Hisings Backa (SE)
(74) Representative: Valea AB

(57) **Abstract**

A safety system (400) for detecting a critical condition in a battery pack (300, 300', 300") comprising a plurality of battery units (310, 310', 310"), the safety system comprising:
a control unit (410) configured to obtain measurement data relating to a battery unit voltage and/or a battery unit temperature of at least some of the plurality of battery units, and to, based on the obtained measurement data, detect a critical condition of the battery pack,
a stand-alone power supply (420) configured to supply electric power to the safety system,
a stand-alone communication interface (430) configured to provide and/or communicate information relating to any critical condition of the battery pack detected by the control unit.

## Description

### TECHNICAL FIELD

The invention relates to a safety system, a battery pack comprising the safety system, an electric energy storage system comprising the battery pack and a vehicle comprising the electric energy storage system.

The invention can be applied in battery packs for use in electric vehicles or vessels, such as trucks, buses, marine boats, passenger cars, and construction equipment. The electric vehicles may be fully or partly electric. Fully electric vehicles may be referred to as battery electric vehicles or pure-electric vehicles. Partly electric vehicles may be referred to as hybrid electric vehicles, plug-in hybrid electric vehicles or just hybrid vehicles. Although the invention will be described with respect to an electric bus, the invention is not restricted to a system for use in this particular vehicle, but may also be used in other hybrid or electric vehicles such as electric trucks, electric construction equipment, and electric passenger cars. The invention may also be applied in any other type of electric vehicle or marine vessel, such as in electric powered construction equipment, wheel loaders, articulated haulers, dump trucks, excavators, backhoe loaders, etc. The invention is further applicable in stationary electric energy storage systems, such as in a 2^{nd} life application of battery packs used in any of the above mentioned applications in a 1^{st} life of the battery packs.

### BACKGROUND

Batteries are becoming a more common source of power for providing propulsion for vehicles, also for heavy duty vehicles such as buses and trucks. Such batteries are often rechargeable batteries and typically include a number of battery cells that may be connected in series or in parallel forming a complete battery pack for the vehicle. The vehicle may be provided with several such battery packs, depending on the requirements of a user of the vehicle.

Battery powered electric propulsion provides many benefits, for example, reduced emission levels and more silent vehicles. Battery packs of the kind used in vehicles may also be used in e.g. stationary electric energy storage systems, for example to stabilize a grid or to store excess energy.

However, there may be hazards involved if the battery pack becomes damaged so that a critical condition occurs in the battery pack. Damages that cause critical conditions may occur during transporting and handling of the battery pack or when a vehicle carrying the battery pack is involved in an accident, a fire or a similar event. Damage can also occur due to ageing and defects within the battery pack. An example of such a critical condition is a so called thermal runaway, during which the battery temperature increases rapidly in an uncontrolled manner. This may lead to severe damages on e.g. the vehicle or warehouse in which the battery pack is located and may ultimately cause a fire. Another example of a critical condition is a short-circuit in the battery pack.

Due to the hazards involved when a critical condition arises in a battery pack, there is a need to detect a critical condition in a battery pack and to inform a user about it, so that they can take the precautionary measures required and handle the battery pack in a safe manner. It is desirable that the user can assess the condition of the battery pack and take necessary steps to handle it in a safe manner, for example by keeping a safe distance to the battery pack, arranging for safe transportation thereof, monitoring the battery pack to ensure that no fire starts therein, or arranging for additional cooling of the battery pack.

As discussed above, the critical condition may occur in situations when the battery pack is not in use, such as during storage and transportation. As further discussed, it may also occur in situations when the battery pack is in use, e.g. in a vehicle, but when its normal connections to external systems, e.g. systems of the vehicle, are disconnected and/or non-functional due to, e.g., an accident or fire. Thus, it is essential that the critical condition, if present, can be detected in a safe way and that a user can be informed about a critical condition also in situations such as described above.

### SUMMARY

An object of the invention is to provide an in at least some aspect improved system for detecting and communicating that a critical condition is present in a battery pack to a user of the battery pack and/or to other persons who need to be warned about the critical condition.

According to a first aspect of the invention, the object is achieved by a safety system according to claim 1. The safety system is adapted to detect a critical condition in a battery pack comprising a plurality of battery units and comprises a control unit, a stand-alone power supply, and a stand-alone communication interface. The control unit is configured to obtain measurement data relating to a battery unit voltage and/or a battery unit temperature of at least some of the plurality of battery units, and to, based on the obtained measurement data, detect a critical condition of the battery pack. The stand-alone power supply is configured to supply electric power to the safety system. The stand-alone communication interface is configured to provide and/or communicate information relating to any critical condition of the battery pack detected by the control unit.

By providing a control unit configured to obtain measurement data relating to a battery unit voltage and/or a battery unit temperature, a critical condition in a battery pack, such as, for example, a thermal runaway, can be detected. Since the safety system is battery pack specific, i.e. configured to detect and provide information relating to a critical condition within an individual battery pack, it is possible to distinguish between damaged and non-damaged battery packs within an energy storage system comprising several battery packs. Thus, damaged battery packs may be efficiently identified and replaced, without affecting battery packs that are intact.

Since the stand-alone communication interface is configured to provide and/or communicate information relating to any critical condition of the battery pack, the same communication interface is used for communication, regardless of in which battery unit of the battery pack the critical condition was detected. Thus, a user can easily identify an affected battery pack, and access information regarding a critical condition in any one of the individual battery units therein via the common communication interface of the battery pack.

As used herein, the term "stand-alone power supply" refers to a power supply which is designated to provide power only to the safety system, and which is capable of doing so independently from other power supplies, such as the battery pack itself or an external power supply. The stand-alone power supply may e.g. be a battery. In a similar manner, the term "stand-alone communication interface" refers to a communication interface that is used only by the safety system. Thus, the stand-alone power supply and the stand-alone communication interface enable the safety system to function properly also in situations when there is no physical and/or electronic connection between the safety system and an external power supply and/or an external communication interface. Such a situation may for example arise as a result of an accident causing malfunction of a vehicle in which the battery pack is used, but it may also arise during storage of the battery pack in a warehouse, or during transportation of the battery packs, i.e. when the battery packs are not connected to any power system. Purely by way of example, an external power supply may be a power supply of a vehicle or a mains grid, and an external communication interface may be a communication interface of a vehicle in which the battery pack is provided, or a communication interface of an energy storage system in which the battery pack is comprised.

Some or all components of the safety system may be integrated in a common housing, which is adapted to be mounted to a body or housing of the battery pack.

The battery pack comprises a plurality of battery units. The term "battery unit" is herein intended to encompass an individual battery cell, as well as a battery module comprising a plurality of battery cells, such as a battery string comprising at least two battery cells connected in series.

The control unit may be configured to obtain measurement data collected by existing sensors of the battery pack, and/or the safety system may comprise its own sensors for collecting measurement data.

Optionally, the control unit is configured to obtain measurement data relating to the battery unit voltage of each one of the plurality of battery units, i.e. of each battery unit within the battery pack, such as of each battery cell within the battery pack. For example, voltage sensors for measuring the voltage of each battery unit and communicating the collected measurement data to the control unit may be provided.

Optionally, the control unit is configured to obtain measurement data relating to the battery unit temperature of each one of the plurality of battery units, i.e. of each battery unit within the battery pack, such as of each battery cell within the battery pack. Temperature sensors for measuring and communicating the temperature of each battery unit may preferably be provided for this purpose. However, it may also be possible to position temperature sensors strategically within the battery pack, such that one temperature sensor may be used for sensing the temperature of more than one battery unit. In this case, the control unit may be configured to estimate the temperature of a particular battery unit based on its position with respect to the temperature sensors.

By obtaining measurement data relating to the battery unit voltage and/or battery unit temperature of each one of the plurality of battery units, the control unit can detect a critical condition in a battery pack without delay since the voltage and temperature of the individual battery units, in particular of the individual battery cells, are early indicators of a critical condition within the battery pack.

Optionally, the stand-alone communication interface is configured to, in response to the detection of a critical condition by the control unit, communicate and/or provide information relating to the critical condition from the safety system to a remotely located user. By "remotely located" is herein intended located at a safe distance from the battery pack.

By communicating and/or providing information relating to the critical condition from the safety system to a remotely located user, the user can be informed about a critical condition in a battery pack without having to be in the immediate vicinity of the battery pack. As examples, the user can be informed about the critical condition of the battery pack without having to perform measurements on the battery pack, or, in the case when the battery pack is used in a vehicle, without having to be inside or enter a compartment of the vehicle to read out information from an instrument cluster of the vehicle. For this purpose, the communication interface may be configured to be remotely accessed by a user, such as via wireless communication. The user may thereby gain access to information available in the safety system, such as raw measurement data and/or derived information regarding e.g. which one or which ones of the battery units that are damaged.

Optionally, the control unit is configured to detect a critical condition of the battery pack by determining whether a predetermined criterion is fulfilled for any one of the battery units in the battery pack. The predetermined criterion should be based on the obtained temperature and/or voltage of the battery units. In this way, the safety system can provide a warning to a user that a critical condition applies in the battery pack if any single one of the battery units within the battery pack fulfils the predetermined criterion. In other words, a critical condition arising on a battery unit level can be communicated to the user. The actual criterion may be set depending on e.g. battery cell type.

Optionally, the predetermined criterion is fulfilled if the battery unit voltage of any one of the battery units is of a magnitude below a predefinable voltage threshold magnitude and/or if the battery unit temperature of any one of the battery units is above a predefinable temperature threshold value.

In this way, a thermal runaway within any one of the battery units may be efficiently detected, since such a condition is associated with a low voltage magnitude and a high temperature of the battery unit. It may also be possible to set a predetermined criterion such that it is fulfilled if a temperature gradient over time is above a predefinable temperature gradient, i.e. if the temperature is rapidly increasing.

Optionally, the stand-alone communication interface is at least one of a visual communication means, an audible communication means, a controller area network interface and a personal area network interface.

A visual or audible communication means can provide information, e.g., about a critical condition in a battery pack, to a user that is within seeing or hearing distance from the battery pack. The visual or audible signal may be adapted so that it is easy for the user to understand that there is a critical condition, problem, or malfunction in the battery pack, even if the user is not a specialist within the field of battery packs. Examples of such users may be emergency rescue personnel or warehouse workers. Different colours, flashing patterns, frequencies, volumes, visible and/or audible warning messages, etc., may be used for this purpose.

A controller area network interface or personal area network interface can provide information about a critical condition in a battery pack also to a user that is not within seeing or hearing distance from the battery pack, but for whom the information about the critical condition is important. Examples of such users may be vehicle owners, technicians, battery handling personnel, or warehouse managers. It can also provide information to a user which is within seeing or hearing distance from the battery pack, but who, for some reason, cannot perceive the visual or audible signal. Moreover, the controller area network interface or personal area network interface can provide information relating to the condition within the individual battery units of the battery pack. Such information may be in the form of measurement data, and/or information relating to in which battery unit the critical condition is detected, such as which battery units fulfil a predetermined criterion as mentioned above. The controller area network interface and/or the personal area network interface should be remotely accessible, i.e. possible to access using wireless communication.

If a visual communication means is provided, it should be configured to be visibly attached to the battery pack, such as to a body or housing of the battery pack.

It is to be noted that a combination of visual and/or audible communication means and/or network interface(s) may be provided within the same common stand-alone communication interface of the battery pack. In this way, a clear warning signal may be sent using the visual and/or audible communication means, while more detailed information regarding the critical condition may be provided via the network interface(s).

Optionally, the stand-alone power supply comprises a rechargeable battery. The rechargeable battery may be configured to be charged using either a dedicated power source, or to be charged by the battery pack, or to be charged by any other external power source, such as during charging and/or service of the battery pack. By providing a rechargeable battery, it is not necessary to replace the stand-alone power supply as long as charging can be performed when necessary. The rechargeable battery may be relatively small compared to the battery pack.

Optionally, the safety system further comprises at least one photo-voltaic module configured for charging of the at least one rechargeable battery.

By providing at least one photo-voltaic module configured for charging of the at least one rechargeable battery, the rechargeable battery can be continuously charged during use and/or storage of the battery pack, as long as the light conditions allow for charging. Thus, the charging level of the rechargeable battery is maintained with reduced or even eliminated need for external chargers. The function of the safety system is thereby not dependent on access to external chargers.

According to a second aspect of the invention, the object is achieved by a battery pack according to claim 10. The battery pack comprises a plurality of battery units, means for measuring the battery unit voltage, and/or the battery unit temperature of at least some of the plurality of battery units, and the safety system according to the first aspect of the invention. Effects and features of the second aspect of the invention are largely analogous to those described above in connection with the first aspect.

By providing the battery pack with means for measuring the battery unit voltage, and/or the battery unit temperature of at least some of the plurality of battery units, and the safety system as disclosed above, a critical condition in the battery pack can be detected and information relating to any detected critical condition can be provided and/or communicated.

Optionally, the battery pack comprises means for measuring the battery unit voltage of each one of the plurality of battery units. The means for measuring the voltage may be voltage sensors configured to measure a terminal voltage of each battery unit, such as of each battery cell, within the battery pack.

Optionally, the battery pack comprises means for measuring the battery unit temperature of each one of the plurality of battery units. The means for measuring the temperature may be temperature sensors.

By providing means for measuring the battery unit voltage and/or battery unit temperature of each one of the plurality of battery units, a critical condition in a battery pack can be detected without delay.

Optionally, the stand-alone communication interface comprises at least a visual communication means visibly attached to an external surface of the battery pack.

By providing at least a visual communication means which is visibly attached to an external surface of the battery pack, information about a critical condition in a battery pack can be communicated to a user who is within seeing distance from the battery pack. The visual signal is easy to detect and may be adapted so that it is easy for the user to understand that there is a critical condition in the battery pack, even if the user is not a specialist within the field of battery packs. Examples of such users may be emergency rescue personnel or warehouse workers.

According to a third aspect of the invention, the object is achieved by an electric energy storage system of a vehicle according to claim 14. The electric energy storage system comprises at least one battery pack according to the second aspect of the invention. Effects and features of the third aspect of the invention are largely analogous to those described above in connection with the first and second aspects.

By providing an above-described battery pack comprising an above-described safety system in an electric energy storage system, a critical condition in the battery pack of the electric energy storage system can be detected and information relating to any detected critical condition can be provided and/or communicated. This is particularly advantageous for an electric energy storage system comprising a plurality of battery packs, each comprising a safety system according to the first aspect of the invention. The safety system comprised in each battery pack allows a user to quickly identify in which battery pack there is a critical condition. Thus, the battery pack having the critical condition may, for example, be removed from the electric energy storage system and may be handled separately during transportation.

According to a fourth aspect of the invention, the object is achieved by a vehicle according to claim 15 comprising the electric energy storage system according to the third aspect of the invention. Effects and features of the fourth aspect of the invention are largely analogous to those described above in connection with the first, second and third aspects.

By providing an electrical energy storage system as described above in a vehicle, a critical condition in a battery pack onboard the vehicle can be detected and information relating to any critical condition can be provided and/or communicated. Thus, a user, such as a driver or a workshop mechanic, can be informed that there is a critical condition in a battery pack, and the user can easily identify in which battery pack a critical condition applies. If the vehicle is involved in an accident, a user such as emergency rescue personnel can be informed that there is a critical condition in a battery pack, and the user can easily identify in which battery pack there is a critical condition, and take the measures necessary to avoid a hazardous situation.

Further advantages and advantageous features of the invention are disclosed in the following description and in the dependent claims.

### BRIEF DESCRIPTION OF THE DRAWINGS

With reference to the appended drawings, below follows a more detailed description of embodiments of the invention cited as examples.

In the drawings:
- Fig. 1: is a schematic drawing illustrating a vehicle,
- Fig. 2: is a block diagram illustrating an electric energy storage system,
- Fig. 3: is a block diagram illustrating a battery pack comprising a safety system according to an embodiment of the invention, and
- Fig. 4: is a schematic drawing illustrating a battery pack and a safety system according to an embodiment of the invention.

The drawings are schematic and not necessarily drawn to scale.

### DETAILED DESCRIPTION OF EXAMPLE EMBODIMENTS OF THE INVENTION

In the present detailed description, embodiments of the system according to the present invention are mainly described with reference to an all-electric bus, comprising a propulsion system in the form of battery powered electric motors. However, it should be noted that various embodiments of the described invention are equally applicable for a wide range of hybrid and electric vehicles and vessels, and also for stationary applications and/or during storage of the battery pack in a warehouse or similar.

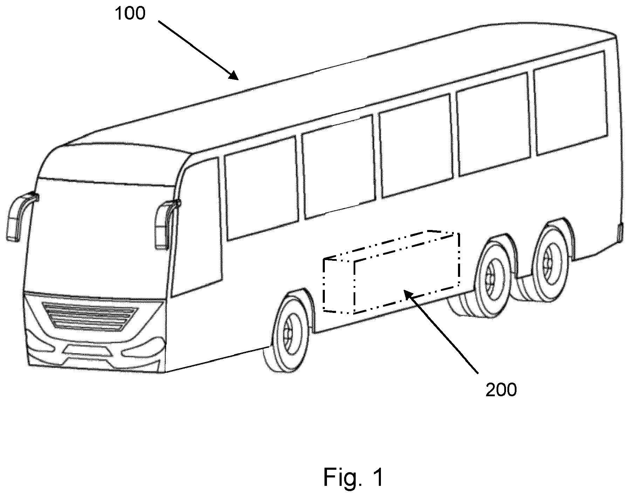

Fig. 1 shows a simplified perspective view of an all-electric vehicle in the form of a bus 100, which is equipped with an electric energy storage system (ESS) 200. The energy from the electric energy storage system 200 is primarily used for propulsion of the bus 100 by means of at least one electric machine (not shown). Of course, the energy from the electric energy storage system 200 may also be used by other loads in addition to or instead of the electric machine used for propulsion of the bus 100, for example auxiliary systems requiring electric power, and/or an on-board charger, and/or a power take-off.

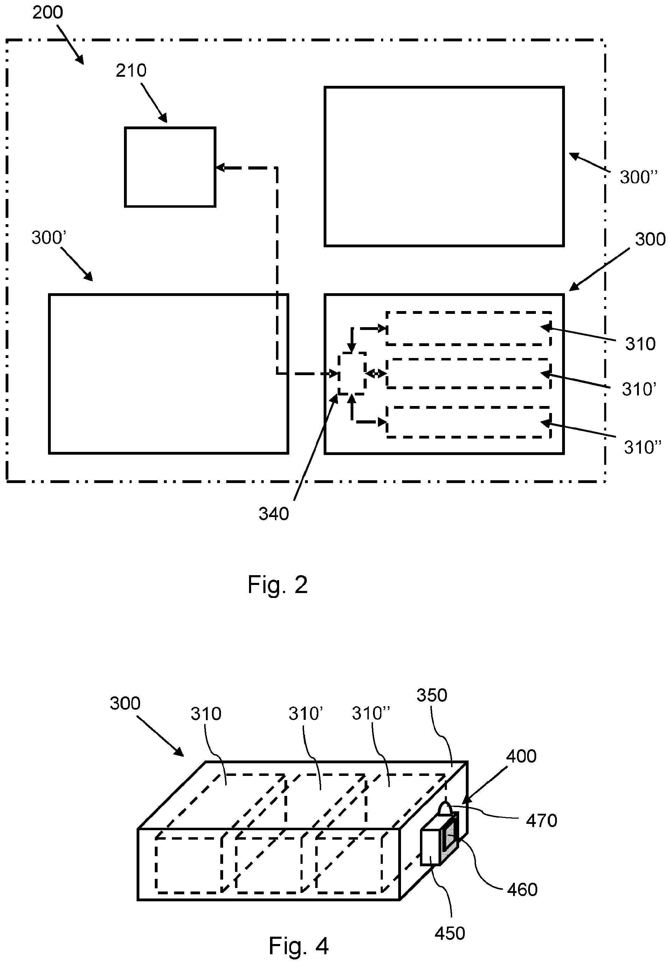

As may be gleaned from Fig. 2, the electric energy storage system 200 comprises a plurality of battery packs 300, 300', 300" that may be connected in series or in parallel. Each battery pack 300, 300', 300" comprises a plurality of interconnected battery units 310, 310', 310". It should be noted that the setup in Fig. 2, showing an electric energy storage system 200 comprising three battery packs 300, 300', 300", each battery pack 300, 300', 300" comprising three battery units 310, 310', 310", is purely intended for illustrational purposes and should in no way be construed as limiting for the invention. Although not illustrated in Fig. 2, each battery unit 310, 310', 310" may be an individual battery cell or a battery module comprising a plurality of battery cells, such as a battery string comprising at least two battery cells connected in series so as to provide an output DC voltage having a desired voltage level. Purely by way of example, each battery pack 300, 300', 300" may comprise a plurality of such battery modules connected in parallel.

Suitably, the battery cells are of lithium-ion type, but other types may also be used. The number of battery cells per battery pack 300, 300', 300" may be in the range of 50 to 500 cells, or up to many thousands of cells in the case of small format cells.

Each battery pack 300, 300', 300" may comprise a battery management unit (BMU) 340 configured for managing the battery pack. The BMU 340 receives and processes measurement data relating to current, voltage and temperature of the battery units 310, 310', 310" within associated battery pack 300 and may also estimate battery states of the battery pack 300, such as state-of-charge (SoC), state-of-health (SoH), state of power (SoP) and state of energy (SoE). An ESS control unit 210 may also be provided, which is configured for controlling the ESS 200 during operation of the bus 100. The ESS control unit 210 can also be configured for determining parameters indicating and controlling the condition or capacity of the ESS 200 and/or of battery packs 300, 300', 300" thereof, such as the battery states mentioned above, based on data received from the BMU of each battery pack, herein illustrated by the BMU 340 of the battery pack 300.

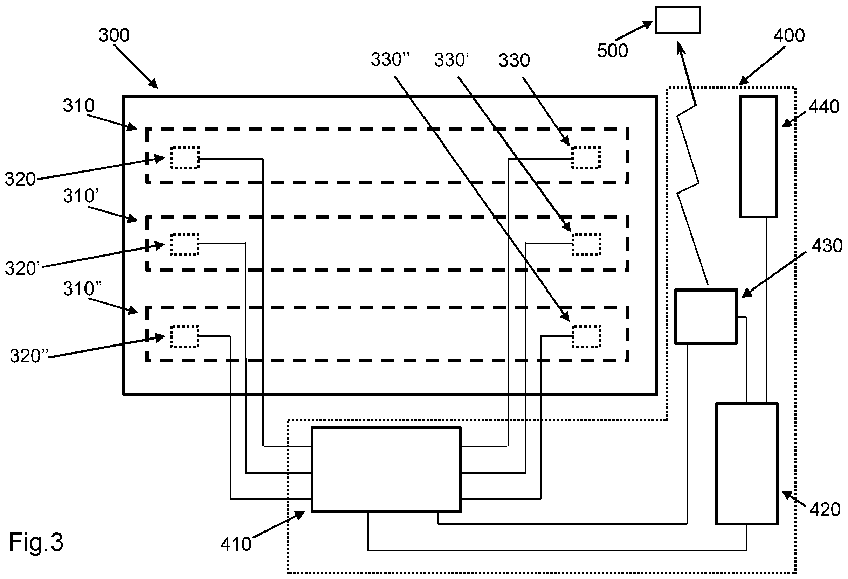

In Fig. 3, a battery pack 300 from the plurality of battery packs 300, 300', 300" is shown in greater detail. As already discussed, the battery pack 300 comprises a plurality of battery units 310, 310', 310". The battery pack 300 furthermore comprises a safety system 400 according to an embodiment of the invention, which safety system 400 is adapted to detect a critical condition in the battery pack 300 based on measurement data relating to battery unit temperature and/or voltage. The safety system 400 comprises a control unit 410, a stand-alone power supply 420 and a stand-alone communication interface 430.

In the embodiment illustrated in Fig. 3, the battery pack 300 comprises means 320, 320', 320"; 330, 330', 330" for measuring the battery unit voltage and the battery unit temperature of each one of the plurality of battery units 310, 310', 310", i.e. voltage sensors 320, 320', 320" and temperature sensors 330, 330', 330", respectively. These sensors 320, 320', 320"; 330, 330', 330" may advantageously be the same sensors that are used to collect measurement data used by the BMU 340 (not illustrated in fig. 3). Alternatively, some or all of the sensors 320, 320', 320"; 330, 330', 330" may be dedicated for use with the safety system 400. However, it may also be sufficient to have means for measuring the battery unit voltage and/or means for measuring the battery unit temperature of only some of the battery units 310, 310', 310".

The control unit 410 is configured to obtain measurement data relating to a battery unit voltage and/or a battery unit temperature of at least some of the plurality of battery units 310, 310', 310" from the sensors 320, 320', 320"; 330, 330', 330", such as via a wired or a wireless connection. Based on the obtained measurement data, the control unit 410 is configured to detect a critical condition in the battery pack 300. The critical condition may e.g. be a short-circuit or a thermal runaway within the battery pack 300.

Purely by way of example, the control unit 410 may be configured to detect a critical condition of the battery pack 300 by determining whether a predetermined criterion is fulfilled for any one of the battery units 310, 310', 310" in the battery pack 300. The predetermined criterion may for example be considered to be fulfilled if the battery unit voltage of any one of the battery units 310, 310', 310" is of a magnitude below a predefinable voltage threshold magnitude. The predefined voltage threshold magnitude may be set to a value which is indicative of a risk for thermal runaway within the battery pack 300. The predetermined criterion may alternatively, or additionally, be set so that it is considered to be fulfilled if the battery unit temperature of any of the battery units 310, 310', 310" is above a predefinable temperature threshold value. This may also indicate a thermal runaway within the battery pack 300. The criterion may be set so that a critical condition is determined to be detected if at least one of the voltage related criterion and the temperature related criterion is considered fulfilled. The actual voltage threshold magnitude and temperature threshold value should be defined depending on battery cell type, such as by the battery cell manufacturer, since in particular the voltage may vary depending on cell chemistry.

The stand-alone power supply 420 may be a rechargeable battery which may be charged by means of at least one photo-voltaic module 440. However, other methods for charging, such as by using energy from the battery pack 300 or an external power source (not shown), are not excluded. The stand-alone power supply 420 supplies power to the safety system 400 and its components and preferably also to the means 320, 320', 320"; 330, 330', 330" for measuring the battery unit voltage and/or the battery unit temperature, but not to any other consumers.

If the system comprises one or more photo-voltaic modules 440, these are preferably located on the outside of the battery pack 300, in a position where they are likely to be exposed to light. Optionally, the photo-voltaic modules 440 are configured to be movable, so that their positions can be altered depending on the current use of the battery pack 300 or other conditions, e.g., the light conditions in a warehouse. It is conceivable that the photo-voltaic modules 440 may be located in another position than on the outside of the battery pack 300, as long as the position is suitable for that purpose.

The stand-alone communication interface 430 may be configured to passively provide and/or to actively communicate information relating to any critical condition of the battery pack 300 detected by the control unit 410. Thus, information and data stored in the control unit 410 may be accessed by a user via the stand-alone communication interface 430. The stand-alone communication interface 430 is used only by the safety system 400, and thus it communicates and/or provides only information related to the safety system 400, and in particular information related to any critical condition detected by the control unit 410. The communication interface 430 may also be used to communicate any problem or malfunction of the safety system 400 itself, such as a low battery level of the stand-alone power supply 420 or malfunctioning sensors 320, 320', 320"; 330, 330', 330".

The stand-alone communication interface 430 is configured to communicate and/or provide information to a remotely located user 500. For example, the stand-alone communication interface 430 may comprise a visual communication means, such as a warning lamp, which may be used to actively communicate that a critical condition has been detected to anyone within seeing distance. A visual signal communicated by the visual communication means may be adapted to help the remotely located user 500 to understand if any critical condition has been detected in the battery pack 300, or if there is any problem or malfunction of the safety system 400. The visual signal may further be adapted to reflect a degree of severity of the detected condition in the battery pack 300. Purely by way of example, the visual communication means may display a red, flashing signal when any critical condition has been detected in the battery pack 300, a yellow, steady signal when an energy level in the stand-alone power supply 420 is below a first threshold charge level, and a yellow, flashing signal when the energy level in the stand-alone power supply 420 is below a second threshold charge level. The stand-alone communication interface 430 may alternatively or additionally comprise an audible communication means, such as a loudspeaker, which may be used to actively communicate that a critical condition has been detected to anyone within hearing distance. An audible signal communicated by the audible communication means may, e.g., be in the form of a tone, a series of tones, or a spoken message. Preferably, the audible signal may be adapted in a manner analogous to that described above in connection with the visual signal to help the remotely located user 500 understand if any critical condition has been detected in the battery pack 300, or if there is a problem or malfunction of the safety system 400, and also the severity of the detected condition. The stand-alone communication interface 430 may additionally, or alternatively, comprise a remotely accessible controller area network interface or personal area network interface, which may be configured to actively communicate information by e.g. sending a message / signal that a critical condition has been detected, or that a problem or malfunction of the safety system 400 has been identified, such as a text message to a mobile phone and/or a message to a remotely located surveillance system. It may further be configured to provide information stored in the control unit 410 when accessed by a user. The stand-alone communication interface 430 may also send data to a remote server for storage. Thus, the remotely located user 500 may be a person that is located within seeing or hearing distance from the battery pack 300, or it may be a person that is located farther away.

The safety system 400 may also be connected to the BMU 340 and/or to the ESS control unit 210 so that it may be readily identified by the BMU or ESS control unit if, for some reason, the safety system 400 is not functional. Thus, the BMU 340 and/or the ESS control unit 210 may trigger a warning signal if it is detected that the safety system 400 is not functional.

As schematically illustrated in Fig. 4, the components of the safety system 400, such as the control unit 410, the power supply 420 and the communication interface 430 shown in Fig. 3, may be mounted together in a common housing 450 or similar on an external surface of the battery pack 300, such as on a battery pack housing 350. In the embodiment shown in Fig. 4, the communication interface comprises on one hand visual communication means in the form of a display 460 and a warning lamp 470, and on the other hand a remotely accessible controller area network interface (not illustrated in Fig. 4).

However, the components 410, 420, 430 may also be mounted separately with, for example, any visible communication means of the communication interface 430 visibly mounted on an external surface of the battery pack 300. The components 410, 420, 430, or preferably the common housing, may be adapted to be moveable. In particular, the common housing and/or the communication interface 430 may be adapted to be mounted in different positions on the external surface of the battery pack 300. Thus, the components 410, 420, 430 or the common housing can be positioned differently on the same battery pack in different applications or different situations as deemed suitable. Purely by way of example, when the battery pack 300 is stored in a warehouse, the components 410, 420, 430 may be positioned on an end of the battery pack 300 and when the battery pack 300 is used in a vehicle 100, the components 410, 420, 430 may be positioned on a top surface of the battery pack 300. Advantageously and regardless of if the components 410, 420, 430 or the common housing are adapted to be moveable or not, if the battery pack 300 is used in a vehicle 100, the components 410, 420, 430 or the common housing should be mounted in a position where the components 410, 420, 430 are least likely to be damaged if the vehicle 100 is involved in an accident.

In the embodiment illustrated above, the safety system 400 is applied in a battery pack 300, 300', 300" of a vehicle 100. However, the safety system 400 may advantageously be used also with battery packs outside a vehicle application, such as in a stationary energy storage system, or in a vessel, or during storage of the battery pack in e.g. a warehouse, or during transport of the battery pack.

It is to be understood that the present invention is not limited to the embodiments described above and illustrated in the drawings; rather, the skilled person will recognize that many changes and modifications may be made within the scope of the appended claims.

## Claims

1. A safety system (400) for detecting a critical condition in a battery pack (300, 300', 300") comprising a plurality of battery units (310, 310', 310"), the safety system (400) comprising:
- a control unit (410) configured to obtain measurement data relating to a battery unit voltage and/or a battery unit temperature of at least some of the plurality of battery units (310, 310', 310"), and to, based on the obtained measurement data, detect a critical condition of the battery pack (300, 300', 300"),
- a stand-alone power supply (420) configured to supply electric power to the safety system (400),
- a stand-alone communication interface (430) configured to provide and/or communicate information relating to any critical condition of the battery pack (300, 300', 300") detected by the control unit (410).

2. The safety system (400) according to claim 1, wherein the control unit (410) is configured to obtain measurement data relating to the battery unit voltage of each one of the plurality of battery units (310, 310', 310").

3. The safety system (400) according to claim 1 or 2, wherein the control unit (410) is configured to obtain measurement data relating to the battery unit temperature of each one of the plurality of battery units (310, 310', 310").

4. The safety system (400) according to any of the preceding claims, wherein the stand-alone communication interface (430) is configured to, in response to the detection of a critical condition by the control unit (410), communicate and/or provide information relating to the critical condition from the safety system (400) to a remotely located user (500).

5. The safety system (400) according to any of the preceding claims, wherein the control unit (410) is configured to detect a critical condition of the battery pack (300, 300', 300") by determining whether a predetermined criterion is fulfilled for any one of the battery units (310, 310', 310") in the battery pack (300, 300', 300").

6. The safety system (400) according to claim 5, wherein said predetermined criterion is fulfilled if said battery unit voltage of any one of said battery units (310, 310', 310") is of a magnitude below a predefinable voltage threshold magnitude and/or if said battery unit temperature of any one of said battery units (310, 310', 310") is above a predefinable temperature threshold value.

7. The safety system (400) according to any of the preceding claims, wherein the stand-alone communication interface (430) is at least one of a visual communication means (460, 470), an audible communication means, a controller area network interface and a personal area network interface.

8. The safety system (400) according to any of the preceding claims, wherein the stand-alone power supply (420) comprises a rechargeable battery.

9. The safety system (400) according to claim 8, wherein the safety system (400) further comprises at least one photo-voltaic module (440) configured for charging of said at least one rechargeable battery.

10. A battery pack (300, 300', 300") comprising:
- a plurality of battery units (310, 310', 310")
- means (320, 320', 320"; 330, 330', 330") for measuring the battery unit voltage, and/or the battery unit temperature of at least some of the plurality of battery units (310, 310', 310"),
- the safety system (400) according to any one of claims 1 to 9.

11. The battery pack (300, 300', 300") according to claim 10, wherein the battery pack (300, 300', 300") comprises means (320, 320', 320") for measuring the battery unit voltage of each one of the plurality of battery units (310, 310', 310").

12. The battery pack (300, 300', 300") according to claim 10 or 11, wherein the battery pack (300, 300', 300") comprises means (330, 330', 330") for measuring the battery unit temperature of each one of the plurality of battery units (310, 310', 310").

13. The battery pack (300, 300', 300") according to any one of claims 10-12, wherein the stand-alone communication interface (430) comprises at least a visual communication means (460, 470) visibly attached to an external surface of the battery pack (300, 300', 300").

14. An electric energy storage system (200) of a vehicle (100) comprising at least one battery pack (300, 300', 300") according to any one of claims 10 to 13.

15. A vehicle (100) comprising an electric energy storage system (200) according to claim 14.
